# EUROPEAN PATENT APPLICATION

(11) **EP 4 475 185 A1**
(43) Date of publication of application: **11.12.2024**
(21) Application number: 23198852.8
(22) Date of filing: 21.09.2023
(51) Int. Cl.: H01L 25/10, H01L 23/00, H01L 25/065, H01L 25/18, H01L 21/98

(54) **THREE-DIMENSIONAL INTEGRATED CIRCUIT STRUCTURE**

(30) Priority: 07.06.2023 TW 112121285
(71) Applicant: United Microelectronics Corp., Hsin-Chu City 300 (TW)
(72) Inventor: YU, Tsung-Kai, 303 Hukou Township, Hsinchu County (TW); WANG, Chen-Hsiao, 300 Hsinchu City (TW); HSU, Yi-Feng, 300 Hsinchu City (TW); HO, Kai-Kuang, 300 Hsinchu City (TW)
(74) Representative: Isarpatent

(57) **Abstract**

The present invention provides a 3D integrated circuit structure formed by stacking semiconductor structures. The semiconductor structures form a multi-die heterogeneous 3D packaging by direct bonding the bonding pads of re-distribution layers. The same or different dies are used to produce the semiconductor structures through the back-end packaging process, and then hybrid bonding technology is used to stack and interconnect the semiconductor structures. The position of the bonding pad can be redefined by re-distribution layer, thereby overcoming the limitations of chip bonding pad position, chip size and quantity.

## Description

### Field of the Invention

The invention relates to the field of semiconductor technology, in particular to a three-dimensional integrated circuit structure and a manufacturing method thereof.

### Description of the Prior Art

Three-dimensional (3D) integration technology can be used to reduce interconnect delay by reducing the length and the number of interconnect lines on a chip of electronic integrated circuits (ICs) and to realize heterogeneous integration of technologies and systems. 3D integration offers benefits of higher performance, higher density, higher functionality, smaller form factor, and potential cost reduction. With this emerging field, new and improved technologies will be necessary to meet the associated manufacturing challenges.

### Summary of the Invention

It is one object of the present invention to provide an improved three-dimensional integrated circuit structure and a manufacturing method thereof in order to solve the deficiencies or shortcomings of the prior art.

One aspect of the invention provides a three-dimensional (3D) integrated circuit structure including a first semiconductor structure comprising a first plurality of dies molded by a first gap-fill material, and a first re-distribution layer electrically connected to the first plurality of dies. The first re-distribution layer comprises a plurality of first bonding pads and a first insulating layer around the plurality of first bonding pads. The 3D integrated circuit structure further includes a second semiconductor structure comprising a second plurality of dies molded by a second gap-fill material. The second plurality of dies comprises at least one through-silicon via (TSV) die, and a second re-distribution layer electrically connected to the second plurality of dies. The second re-distribution layer comprises a plurality of second bonding pads and a second insulating layer around the plurality of second bonding pads, wherein the plurality of first bonding pads is directly bonded to the plurality of second bonding pads, respectively.

According to some embodiments, the plurality of first bonding pads and the plurality of second bonding pads comprise copper pads.

According to some embodiments, the first insulating layer and the second insulating layer comprise silicon oxide, silicon nitride, or silicon carbonitride.

According to some embodiments, the first insulating layer is directly bonded to the second insulating layer.

According to some embodiments, the 3D integrated circuit structure further includes a third re-distribution layer disposed on a side of the second semiconductor structure opposite to the second re-distribution layer.

According to some embodiments, the 3D integrated circuit structure further includes a plurality of connecting elements disposed on the third re-distribution layer.

According to some embodiments, the plurality of connecting elements comprises solder bumps or solder balls.

According to some embodiments, the TSV die comprises a plurality of through-silicon vias for electrically connecting the second re-distribution layer with the third re-distribution layer.

According to some embodiments, the 3D integrated circuit structure further includes a plurality of conductive posts embedded in the first gap-fill material for electrically connecting to the second re-distribution layer.

According to some embodiments, the first gap-fill material and the second gap-fill material comprise dielectric material or molding compound.

Another aspect of the invention provides a method of fabricating a three-dimensional (3D) integrated circuit structure. A first semiconductor structure is prepared. The first semiconductor structure comprises a first plurality of dies molded by a first gap-fill material, and a first re-distribution layer electrically connected to the first plurality of dies. The first re-distribution layer comprises a plurality of first bonding pads and a first insulating layer around the plurality of first bonding pads. A second semiconductor structure is prepared. The second semiconductor structure comprises a second plurality of dies molded by a second gap-fill material, and a second re-distribution layer electrically connected to the second plurality of dies. The second re-distribution layer comprises a plurality of second bonding pads and a second insulating layer around the plurality of second bonding pads. The first semiconductor structure is hybrid bonded to the second semiconductor structure. The plurality of first bonding pads is directly bonded to the plurality of second bonding pads, respectively.

According to some embodiments, the plurality of first bonding pads and the plurality of second bonding pads comprise copper pads.

According to some embodiments, the first insulating layer and the second insulating layer comprise silicon oxide, silicon nitride, or silicon carbonitride.

According to some embodiments, the first insulating layer is directly bonded to the second insulating layer.

According to some embodiments, the method further comprises the step of: forming a third re-distribution layer on a side of the second semiconductor structure opposite to the second re-distribution layer.

According to some embodiments, the method further comprises the step of: forming a plurality of connecting elements on the third re-distribution layer.

According to some embodiments, the plurality of connecting elements comprises solder bumps or solder balls.

According to some embodiments, the second plurality of dies comprises a through-silicon via (TSV) die, wherein the TSV die comprises a plurality of through-silicon vias for electrically connecting the second re-distribution layer with the third re-distribution layer.

According to some embodiments, the method further comprises the step of: forming a plurality of conductive posts in the first gap-fill material for electrically connecting to the second re-distribution layer.

According to some embodiments, the first gap-fill material and the second gap-fill material comprise dielectric material or molding compound.

Still another aspect of the invention provides a three-dimensional (3D) integrated circuit structure including a first semiconductor structure comprising a first plurality of dies and a plurality of conductive posts molded by a first gap-fill material, and a first re-distribution layer electrically connected to the first plurality of dies and the plurality of conductive posts. The first re-distribution layer comprises a plurality of first bonding pads and a first insulating layer around the plurality of first bonding pads. The 3D integrated circuit structure further includes a second semiconductor structure comprising a second plurality of dies molded by a second gap-fill material, a second re-distribution layer electrically connected to the second plurality of dies, and a third re-distribution layer disposed on a side of the second semiconductor structure opposite to the second re-distribution layer. The second re-distribution layer comprises a plurality of second bonding pads and a second insulating layer around the plurality of second bonding pads. The plurality of first bonding pads is directly bonded to the plurality of second bonding pads, respectively.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a schematic cross-sectional view of a three-dimensional integrated circuit structure according to an embodiment of the present invention.
FIG. 2 is a schematic cross-sectional view of a three-dimensional integrated circuit structure according to another embodiment of the present invention.
FIG. 3 is a schematic cross-sectional view of a three-dimensional integrated circuit structure according to another embodiment of the present invention.
FIG. 4 is a schematic cross-sectional view of a three-dimensional integrated circuit structure according to another embodiment of the present invention.
FIG. 5 is a schematic cross-sectional view of a three-dimensional integrated circuit structure according to another embodiment of the present invention.
FIG. 6 to FIG. 10 are schematic diagrams showing a method for manufacturing a three-dimensional integrated circuit structure according to an embodiment of the present invention.
FIG. 11 to FIG. 15 are schematic diagrams showing a method for manufacturing a three-dimensional integrated circuit structure according to another embodiment of the present invention.
FIG. 16 to FIG. 18, which illustrate a method for forming a three-dimensional integrated circuit structure by module-to-reconstructed module wafer hybrid bonding.
FIG. 19 to FIG. 21 illustrate a fabrication method of the re-constructed module wafer.
FIG. 22 to FIG. 25 illustrate a fabrication method of the re-constructed module wafer.
FIG. 26 to FIG. 29 illustrate another fabrication method of the re-constructed module wafer.

### Detailed Description

In the following detailed description of the disclosure, reference is made to the accompanying drawings, which form a part hereof, and in which is shown, by way of illustration, specific embodiments in which the invention may be practiced. These embodiments are described in sufficient detail to enable those skilled in the art to practice the invention.

Other embodiments may be utilized, and structural, logical, and electrical changes may be made without departing from the scope of the present invention. Therefore, the following detailed description is not to be considered as limiting.

The present invention provides a three-dimensional integrated circuit structure formed by stacking a plurality of semiconductor structures (reconstructed intermediate packages or reconstructed intermediate modules), wherein the plurality of semiconductor structures is directly bonded through the bonding pads of the re-distribution layers, thereby constituting a multi-chip heterogeneous three-dimensional packaging configuration.

The present invention utilizes the same or different dies to manufacture a plurality of semiconductor structures through a back-end packaging process, and then uses a hybrid bonding technology to perform stacking and interconnection of the plurality of semiconductor structures. The position of the bonding pad can be redefined by the re-distribution layer, which overcomes the prior art problem of die bonding pad position, die size and quantity limitations. After the stacking is completed, a bumping process is performed, and then a dicing process is performed to complete the final three-dimensional multi-chip heterogeneous packaging product.

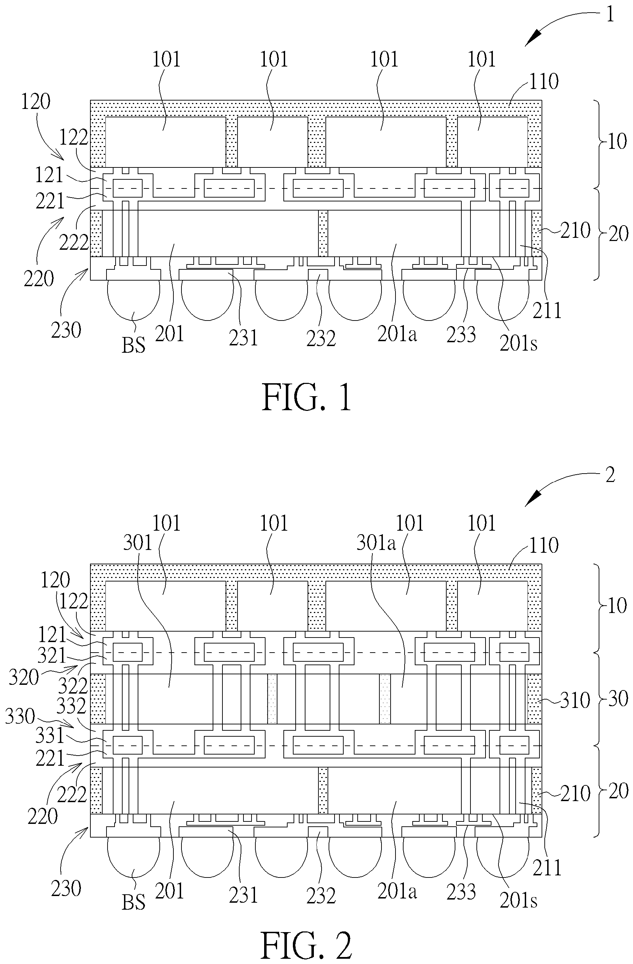

Please refer to FIG. 1, which is a schematic cross-sectional view of a three-dimensional integrated circuit structure according to an embodiment of the present invention. As shown in FIG. 1, the three-dimensional integrated circuit structure 1 comprises a semiconductor structure 10 comprising a plurality of dies 101 molded by a gap filling material 110, and a re-distribution layer 120 electrically connected to the plurality of dies 101. The re-distribution layer 120 includes a plurality of bonding pads 121 and an insulating layer 122 surrounding the plurality of bonding pads 121.

According to an embodiment of the present invention, the plurality of dies 101 may include the same function die and different function dies. The above-mentioned function dies include, but are not limited to, memory devices, sensor devices, processor devices, wireless communication circuits, micro-electromechanical systems (MEMS), digital circuits, analog circuits, or the like. According to an embodiment of the present invention, the plurality of dies 101 may include dummy dies or bridging dies.

According to an embodiment of the present invention, the three-dimensional integrated circuit structure 1 further comprises a semiconductor structure 20 comprising a plurality of dies 201 molded by a gap-fill material 210, and a re-distribution layer 220 electrically connected to the plurality of dies 201. The plurality of dies 201 may include at least one through-silicon via (TSV) die 201a. The re-distribution layer 220 includes a plurality of bonding pads 221 and an insulating layer 222 surrounding the plurality of bonding pads 221. The plurality of bonding pads 121 are respectively directly bonded to the plurality of bonding pads 221 by direct bonding technology. The direct bonding of the bonding pads may include Cu-to-Cu direct bonding.

According to an embodiment of the present invention, the plurality of dies 201 may include the same function dies or different function dies. According to an embodiment of the present invention, the plurality of dies 201 may include dummy dies or bridging dies.

According to an embodiment of the present invention, both the semiconductor structure 10 and the semiconductor structure 20 are re-constructed intermediate packages or re-constructed intermediate modules.

According to an embodiment of the present invention, the three-dimensional integrated circuit structure 1 further includes a re-distribution layer 230 disposed on a side of the semiconductor structure 20 opposite to the re-distribution layer 220. According to an embodiment of the present invention, the three-dimensional integrated circuit structure 1 further includes a plurality of connecting elements BS disposed on the re-distribution layer 230. According to an embodiment of the present invention, the plurality of connecting elements BS may include solder bumps or solder balls. According to an embodiment of the present invention, the re-distribution layer 230 includes a plurality of solder ball pads 231 and an insulating layer 232 surrounding the plurality of solder ball pads 231. According to an embodiment of the present invention, the re-distribution layer 230 further includes an interconnection structure 233 connected to the active surfaces 201s of the plurality of dies 201.

According to an embodiment of the present invention, the plurality of bonding pads 121 and the plurality of bonding pads 221 may include copper pads, but is not limited thereto. According to an embodiment of the present invention, the insulating layer 122 and the insulating layer 222 may include silicon oxide, silicon nitride or silicon carbonitride (SiCN). According to an embodiment of the present invention, for example, the insulating layer 122 and the insulating layer 222 are silicon carbonitride layers. According to an embodiment of the present invention, the insulating layer 122 is directly bonded to the insulating layer 222. According to an embodiment of the present invention, the insulating layer 122 directly contacts the insulating layer 222.

According to an embodiment of the present invention, the TSV die 201a includes a plurality of TSVs 211 for electrically connecting the re-distribution layer 220 with the re-distribution layer 230.

According to an embodiment of the present invention, the gap-fill material 110 and the gap-fill material 210 may include a dielectric material or a molding compound, but are not limited thereto.

Please refer to FIG. 2, which is a schematic cross-sectional view of a three-dimensional integrated circuit structure according to another embodiment of the present invention, wherein like regions, layers or elements are designated by like numeral numbers or labels. As shown in FIG. 2, the three-dimensional integrated circuit structure 2 includes a semiconductor structure 10, a semiconductor structure 20, and a semiconductor structure 30 located between the semiconductor structure 10 and the semiconductor structure 20. According to an embodiment of the present invention, the semiconductor structures 10, 20, and 30 are re-constructed intermediate packages or re-constructed intermediate modules.

According to an embodiment of the present invention, the semiconductor structure 30 includes a plurality of dies 301 molded by a gap-fill material 310, and a re-distribution layer 320 electrically connected to the plurality of dies 301. The plurality of dies 301 may include at least one TSV die 301a. The re-distribution layer 320 includes a plurality of bonding pads 321 and an insulating layer 322 surrounding the plurality of bonding pads 321. The plurality of bonding pads 121 of the semiconductor structure 10 are respectively directly bonded to the plurality of bonding pads 321 of the semiconductor structure 30.

According to an embodiment of the present invention, opposite to the re-distribution layer 320, the semiconductor structure 30 further includes a re-distribution layer 330. The re-distribution layer 330 also includes a plurality of bonding pads 331 and an insulating layer 332 surrounding the plurality of bonding pads 331. The plurality of bonding pads 221 of the semiconductor structure 20 are respectively directly bonded to the plurality of bonding pads 331 of the semiconductor structure 30 by direct bonding technology.

According to an embodiment of the present invention, the plurality of dies 301 may include the same function dies or different function dies. According to an embodiment of the present invention, the plurality of dies 301 may include dummy dies or bridging dies.

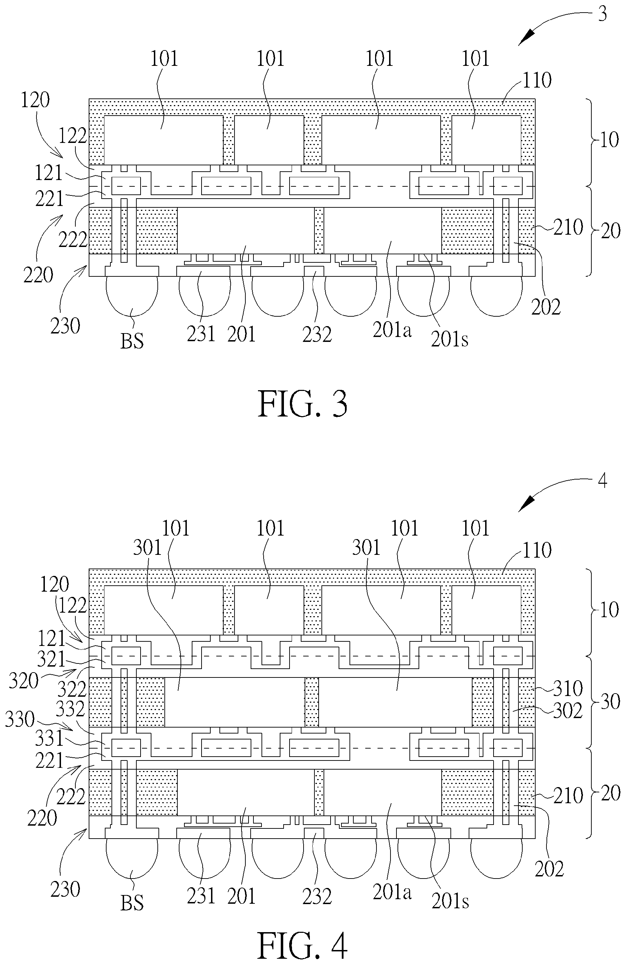

Please refer to FIG. 3, which is a schematic cross-sectional view of a three-dimensional integrated circuit structure according to another embodiment of the present invention, wherein like regions, layers or elements are designated by like numeral numbers or labels. As shown in FIG. 3, the three-dimensional integrated circuit structure 3 also includes a semiconductor structure 10 and a semiconductor structure 20 stacked on each other. According to an embodiment of the present invention, both the semiconductor structure 10 and the semiconductor structure 20 are re-constructed intermediate packages or re-constructed intermediate modules.

According to an embodiment of the present invention, the semiconductor structure 10 includes a plurality of dies 101 molded by a gap-fill material 110, and a re-distribution layer 120 electrically connected to the plurality of dies 101, wherein the re-distribution layer 120 includes a plurality of bonding pads 121, and an insulating layer 122 surrounding the plurality of bonding pads 121.

According to an embodiment of the present invention, the plurality of dies 101 may include the same function dies or different function dies. The above-mentioned function dies include, but are not limited to, memory devices, sensor devices, processor devices, wireless communication circuits, micro-electro-mechanical systems, digital circuits, analog circuits, or the like. According to an embodiment of the present invention, the plurality of dies 101 may include dummy dies or bridging dies.

According to an embodiment of the present invention, the semiconductor structure 20 includes a plurality of dies 201 molded by a gap-fill material 210, and a re-distribution layer 220 electrically connected to the plurality of dies 201. The re-distribution layer 220 includes a plurality of bonding pads 221 and an insulating layer 222 surrounding the plurality of bonding pads 221. The plurality of bonding pads 121 may be respectively directly bonded to the plurality of bonding pads 221 by direct bonding technology. The direct bonding of the bonding pads may include copper-to-copper direct bonding.

According to an embodiment of the present invention, the plurality of dies 201 may include the same function dies or different function dies. According to an embodiment of the present invention, the plurality of dies 201 may include dummy dies or bridging dies.

According to an embodiment of the present invention, the three-dimensional integrated circuit structure 3 further includes a re-distribution layer 230 disposed on a side of the semiconductor structure 20 opposite to the re-distribution layer 220. According to an embodiment of the present invention, the three-dimensional integrated circuit structure 3 further includes a plurality of connecting elements BS disposed on the re-distribution layer 230. According to an embodiment of the present invention, the plurality of connecting elements BS may include solder bumps or solder balls. According to an embodiment of the present invention, the re-distribution layer 230 includes a plurality of solder ball pads 231 and an insulating layer 232 surrounding the plurality of solder ball pads 231. According to an embodiment of the present invention, the re-distribution layer 230 further includes an interconnection structure 233 connected to the active surfaces 201s of the plurality of dies 201.

According to an embodiment of the present invention, the plurality of bonding pads 121 and the plurality of bonding pads 221 may include copper pads, but is not limited thereto. According to an embodiment of the present invention, the insulating layer 122 and the insulating layer 222 may include silicon oxide, silicon nitride or silicon carbonitride. According to an embodiment of the present invention, for example, the insulating layer 122 and the insulating layer 222 are silicon carbonitride layers. According to an embodiment of the present invention, the insulating layer 122 is directly bonded to the insulating layer 222. According to an embodiment of the present invention, the insulating layer 122 directly contacts the insulating layer 222.

According to an embodiment of the present invention, the three-dimensional integrated circuit structure 3 further includes a plurality of conductive posts 202, such as copper pillars, embedded in the gap filling material 210 for electrically connecting the re-distribution layer 220 with the re-distribution layer 230. According to an embodiment of the present invention, the gap-fill material 110 and the gap-fill material 210 may include a dielectric material or a molding compound, but are not limited thereto.

Please refer to FIG. 4, which is a schematic cross-sectional view of a three-dimensional integrated circuit structure according to another embodiment of the present invention, wherein like regions, layers or elements are designated by like numeral numbers or labels. As shown in FIG. 4, the three-dimensional integrated circuit structure 4 includes a semiconductor structure 10, a semiconductor structure 20, and a semiconductor structure 30 located between the semiconductor structure 10 and the semiconductor structure 20. According to an embodiment of the present invention, the semiconductor structures 10, 20, and 30 are re-constructed intermediate packages or re-constructed intermediate modules.

According to an embodiment of the present invention, the semiconductor structure 30 includes a plurality of dies 301 molded by a gap-fill material 310, and a re-distribution layer 320 electrically connected to the plurality of dies 301. The re-distribution layer 320 includes a plurality of bonding pads 321 and an insulating layer 322 surrounding the plurality of bonding pads 321. The plurality of bonding pads 121 of the semiconductor structure 10 may be respectively directly bonded to the plurality of bonding pads 321 of the semiconductor structure 30. According to an embodiment of the present invention, the gap-fill material 310 may include a dielectric material or a molding compound, but is not limited thereto.

According to an embodiment of the present invention, opposite to the re-distribution layer 320, the semiconductor structure 30 further includes a re-distribution layer 330. The re-distribution layer 330 also includes a plurality of bonding pads 331 and an insulating layer 332 surrounding the plurality of bonding pads 331. The plurality of bonding pads 221 of the semiconductor structure 20 may be respectively directly bonded to the plurality of bonding pads 331 of the semiconductor structure 30 by direct bonding technology.

According to an embodiment of the present invention, the plurality of dies 301 may include the same function dies or different function dies. According to an embodiment of the present invention, the plurality of dies 301 may include dummy dies or bridging dies.

According to an embodiment of the present invention, the three-dimensional integrated circuit structure 4 further includes a plurality of conductive posts 202, such as copper pillars, embedded in the gap filling material 210 for electrically connecting the re-distribution layer 220 with the re-distribution layer 230. According to an embodiment of the present invention, the three-dimensional integrated circuit structure 4 further includes a plurality of conductive posts 302, such as copper pillars, embedded in the gap filling material 310 for electrically connecting the re-distribution layer 320 with the re-distribution layer 330.

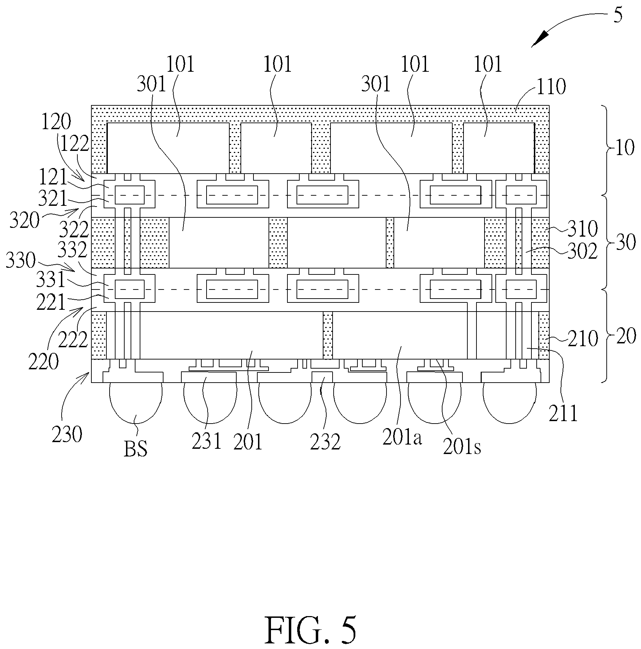

Please refer to FIG. 5, which is a schematic cross-sectional view of a three-dimensional integrated circuit structure according to another embodiment of the present invention, wherein like regions, layers or elements are designated by like numeral numbers or labels. As shown in FIG. 5, the three-dimensional integrated circuit structure 5 includes a semiconductor structure 10, a semiconductor structure 20, and a semiconductor structure 30 located between the semiconductor structure 10 and the semiconductor structure 20. According to an embodiment of the present invention, the semiconductor structures 10, 20, and 30 are re-constructed intermediate packages or re-constructed intermediate modules.

According to an embodiment of the present invention, the semiconductor structure 10 includes a plurality of dies 101 molded by a gap-fill material 110, and a re-distribution layer 120 electrically connected to the plurality of dies 101, wherein the re-distribution layer 120 includes a plurality of bonding pads 121, and an insulating layer 122 surrounding the plurality of bonding pads 121.

According to an embodiment of the present invention, the plurality of dies 101 may include the same function dies or different function dies. The above-mentioned function dies include, but are not limited to, memory devices, sensor devices, processor devices, wireless communication circuits, micro-electro-mechanical systems, digital circuits, analog circuits, or the like. According to an embodiment of the present invention, the plurality of dies 101 may include dummy dies or bridging dies.

According to an embodiment of the present invention, the semiconductor structure 20 includes a plurality of dies 201 molded by a gap-fill material 210, and a re-distribution layer 220 electrically connected to the plurality of dies 201. The plurality of dies 201 may include at least one TSV die 201a. The re-distribution layer 220 includes a plurality of bonding pads 221 and an insulating layer 222 surrounding the plurality of bonding pads 221. The plurality of bonding pads 121 may be respectively directly bonded to the plurality of bonding pads 221 by direct bonding technology. The direct bonding of the bonding pads may include copper-to-copper direct bonding.

According to an embodiment of the present invention, the plurality of dies 201 may include the same function dies or different function dies. According to an embodiment of the present invention, the plurality of dies 201 may include dummy dies or bridging dies.

According to an embodiment of the present invention, the three-dimensional integrated circuit structure 5 further includes a re-distribution layer 230 disposed on a side of the semiconductor structure 20 opposite to the re-distribution layer 220. According to an embodiment of the present invention, the three-dimensional integrated circuit structure 5 further includes a plurality of connecting elements BS disposed on the re-distribution layer 230. According to an embodiment of the present invention, the plurality of connecting elements BS may include solder bumps or solder balls. According to an embodiment of the present invention, the re-distribution layer 230 includes a plurality of solder ball pads 231 and an insulating layer 232 surrounding the plurality of solder ball pads 231. According to an embodiment of the present invention, the re-distribution layer 230 further includes an interconnection structure 233 connected to the active surfaces 201s of the plurality of dies 201.

According to an embodiment of the present invention, the TSV die 201a includes a plurality of TSVs 211 for electrically connecting the re-distribution layer 220 with the re-distribution layer 230.

According to an embodiment of the present invention, the semiconductor structure 30 includes a plurality of dies 301 molded by a gap-fill material 310, and a re-distribution layer 320 electrically connected to the plurality of dies 301. The re-distribution layer 320 includes a plurality of bonding pads 321 and an insulating layer 322 surrounding the plurality of bonding pads 321. The plurality of bonding pads 121 of the semiconductor structure 10 may be respectively directly bonded to the plurality of bonding pads 321 of the semiconductor structure 30. According to an embodiment of the present invention, the gap-fill material 310 may include a dielectric material or a molding compound, but is not limited thereto.

According to an embodiment of the present invention, opposite to the re-distribution layer 320, the semiconductor structure 30 further includes a re-distribution layer 330. The re-distribution layer 330 also includes a plurality of bonding pads 331 and an insulating layer 332 surrounding the plurality of bonding pads 331. The plurality of bonding pads 221 of the semiconductor structure 20 may be respectively directly bonded to the plurality of bonding pads 331 of the semiconductor structure 30 by direct bonding technology.

According to an embodiment of the present invention, the plurality of dies 301 may include the same function dies or different function dies. According to an embodiment of the present invention, the plurality of dies 301 may include dummy dies or bridging dies.

According to an embodiment of the present invention, the three-dimensional integrated circuit structure 5 further includes a plurality of conductive posts 302, such as copper pillars, embedded in the gap filling material 310 for electrically connecting the re-distribution layer 320 with the re-distribution layer 330.

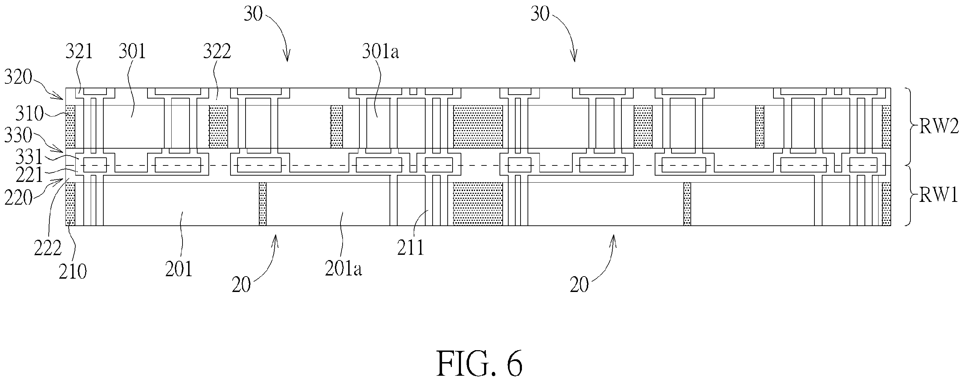

Please refer to FIG. 6 to FIG. 10, which are schematic diagrams showing a method for manufacturing a three-dimensional integrated circuit structure according to an embodiment of the present invention, wherein like regions, layers or elements are designated by like numeral numbers or labels. FIG. 6 to FIG. 10 are illustrated by taking 4-layer semiconductor structure stacking as an example. However, those skilled in the art should understand that in other embodiments, the three-dimensional integrated circuit structure may be 2-layer, 3-layer or more than 4-layer semiconductor structure stacking.

First, as shown in FIG. 6, a re-constructed module wafer RW1 and a re-constructed module wafer RW2 are provided, wherein the re-constructed module wafer RW1 and the re-constructed module wafer RW2 respectively include a plurality of semiconductor structures 20 and semiconductor structures 30 as depicted in FIG. 2. The re-constructed module wafer RW1 and the re-constructed module wafer RW2 are then bonded to each other using a hybrid bonding technique.

According to an embodiment of the present invention, the semiconductor structure 20 includes a plurality of dies 201 molded by a gap-fill material 210, and a re-distribution layer 220 electrically connected to the plurality of dies 201. The plurality of dies 201 may include at least one TSV die 201a. The re-distribution layer 220 includes a plurality of bonding pads 221 and an insulating layer 222 surrounding the plurality of bonding pads 221.

According to an embodiment of the present invention, the plurality of dies 201 may include the same function dies or different function dies. According to an embodiment of the present invention, the plurality of dies 201 may include dummy dies or bridging dies.

According to an embodiment of the present invention, the semiconductor structure 30 includes a plurality of dies 301 molded by a gap-fill material 310, and a re-distribution layer 320 electrically connected to the plurality of dies 301. The plurality of dies 301 may include at least one TSV die 301a. The re-distribution layer 320 includes a plurality of bonding pads 321 and an insulating layer 322 surrounding the plurality of bonding pads 321. According to an embodiment of the present invention, opposite to the re-distribution layer 320, the semiconductor structure 30 further includes a re-distribution layer 330. The re-distribution layer 330 includes a plurality of bonding pads 331 and an insulating layer 332 surrounding the plurality of bonding pads 331. The plurality of bonding pads 221 of the semiconductor structure 20 are respectively directly bonded to the plurality of bonding pads 331 of the semiconductor structure 30.

According to an embodiment of the present invention, the plurality of dies 301 may include the same function dies or different function dies. According to an embodiment of the present invention, the plurality of dies 301 may include dummy dies or bridging dies.

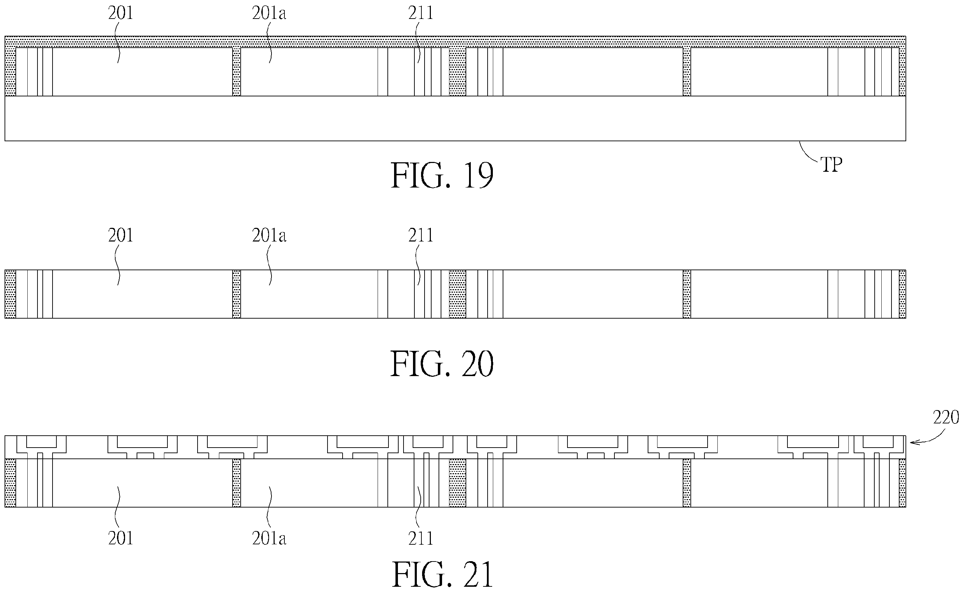

For example, the manufacturing method of the re-constructed module wafer RW1 is illustrated in FIG. 19 to FIG. 21, wherein like regions, layers or elements are designated by like numeral numbers or labels. First, as shown in FIG. 19, re-arranged dies 201 are disposed on the temporary carrier TP in a flip-chip manner, wherein the dies 201 include at least one TSV die 201a. The dies 201 are then molded with a gap filling material 210. As shown in FIG. 20, part of the gap-fill material 210 is removed by grinding to expose the backside of each die 201 and the TSV 211 of the TSV die 201a, and then the temporary carrier TP is removed. As shown in FIG. 21, a re-distribution (RDL) process is then performed to form a re-distribution layer 220 on the exposed backside of the die 201 and on the TSV 211 of the TSV die 201a.

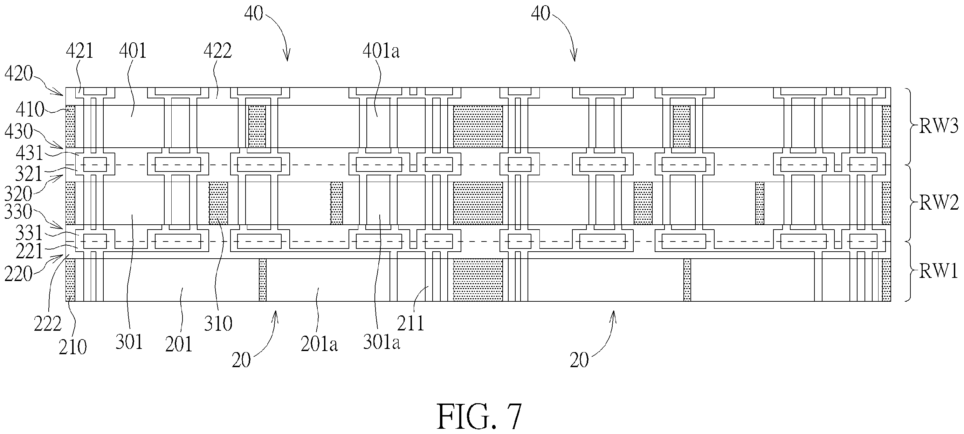

As shown in FIG. 7, a re-constructed module wafer RW3 is provided, wherein the re-constructed module wafer RW3 includes a plurality of semiconductor structures 40. The re-constructed module wafer RW3 and the re-constructed module wafer RW2 are bonded to each other by hybrid bonding technology.

According to an embodiment of the present invention, the semiconductor structure 40 includes a plurality of dies 401 molded by a gap-fill material 410, and a re-distribution layer 420 electrically connected to the plurality of dies 401. The plurality of dies 401 may include at least one TSV die 401a. The re-distribution layer 420 includes a plurality of bonding pads 421 and an insulating layer 422 surrounding the plurality of bonding pads 421. According to an embodiment of the present invention, opposite to the re-distribution layer 420, the semiconductor structure 40 further includes a re-distribution layer 430. The re-distribution layer 430 includes a plurality of bonding pads 431 and an insulating layer 432 surrounding the plurality of bonding pads 431. The plurality of bonding pads 431 of the semiconductor structure 40 may be respectively directly bonded to the plurality of bonding pads 321 of the semiconductor structure 30.

According to an embodiment of the present invention, the plurality of dies 401 may include the same function dies or different function dies. According to an embodiment of the present invention, the plurality of dies 401 may include dummy dies or bridging dies.

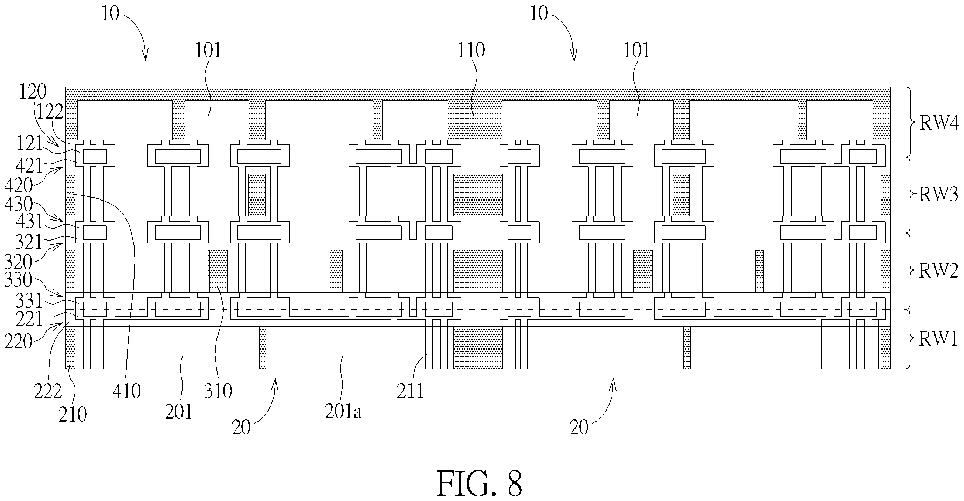

As shown in FIG. 8, a re-constructed module wafer RW4 is provided, wherein the re-constructed module wafer RW4 includes a plurality of semiconductor structures 10 as depicted in FIG. 2. The re-constructed module wafer RW4 and the re-constructed module wafer RW3 are then bonded together using a hybrid bonding technique.

According to an embodiment of the present invention, the semiconductor structure 10 includes a plurality of dies 101 molded by a gap-fill material 110, and a re-distribution layer 120 electrically connected to the plurality of dies 101, wherein the re-distribution layer 120 includes a plurality of bonding pads 121, and an insulating layer 122 surrounding the plurality of bonding pads 121. The plurality of bonding pads 421 of the semiconductor structure 40 may be respectively directly bonded to the plurality of bonding pads 121 of the semiconductor structure 10.

According to an embodiment of the present invention, the plurality of dies 101 may include the same function dies or different function dies. According to an embodiment of the present invention, the plurality of dies 101 may include dummy dies or bridging dies.

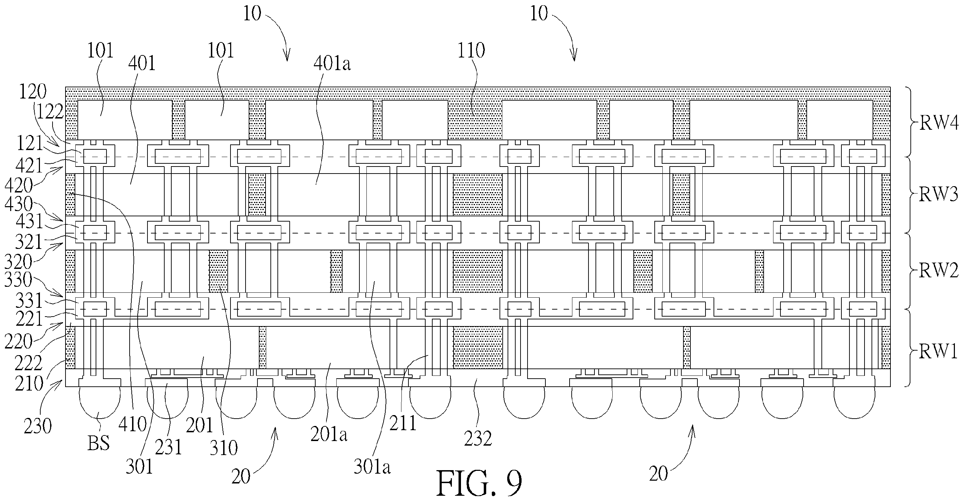

As shown in FIG. 9, a re-distribution layer 230 is then formed on the side of the semiconductor structure 20 opposite to the re-distribution layer 220. The re-distribution layer 230 includes a plurality of solder ball pads 231 and an insulating layer 232 surrounding the plurality of solder ball pads 231. A plurality of connecting elements BS may then be formed on the re-distribution layer 230. According to an embodiment of the present invention, the plurality of connecting elements BS may include solder bumps or solder balls.

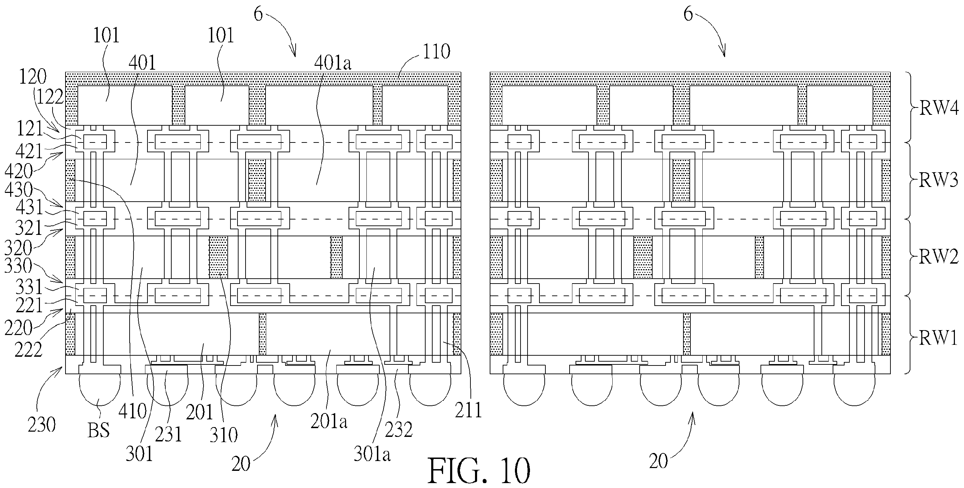

As shown in FIG. 10, a wafer dicing process is then performed to form a plurality of individual three-dimensional integrated circuit structures 6.

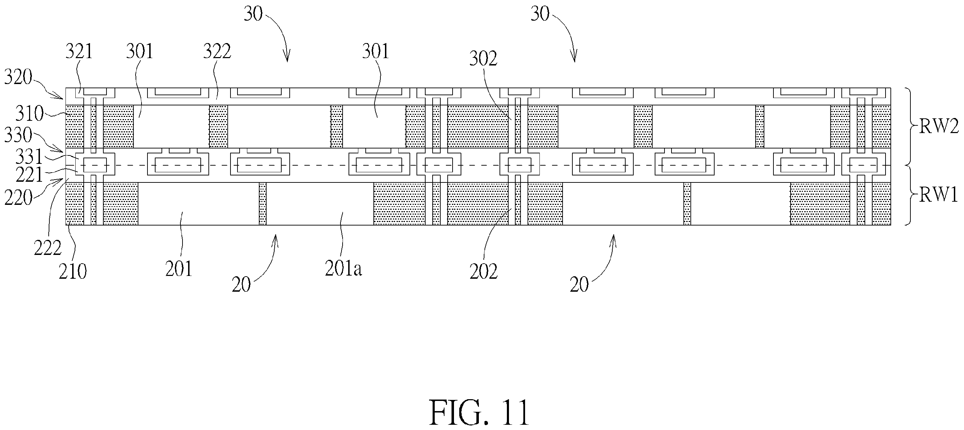

Please refer to FIG. 11 to FIG. 15, which are schematic diagrams showing a method for manufacturing a three-dimensional integrated circuit structure according to another embodiment of the present invention, wherein like regions, layers or elements are designated by like numeral numbers or labels. FIG. 11 to FIG. 15 are illustrated by taking a stack of 4-layer semiconductor structures as an example. However, those skilled in the art should understand that in other embodiments, the three-dimensional integrated circuit structure can be 2-layer, 3-layer or more than 4-layer semiconductor structure stacking.

As shown in FIG. 11, a re-constructed module wafer RW1 and a re-constructed module wafer RW2 are provided, wherein the re-constructed module wafer RW 1 and the re-constructed module wafer RW2 respectively include a plurality of semiconductor structures 20 and semiconductor structures 30 as depicted in FIG. 4. The re-constructed module wafer RW 1 and the re-constructed module wafer RW2 are then bonded to each other using a hybrid bonding technique.

According to an embodiment of the present invention, the semiconductor structure 20 includes a plurality of dies 201 and conductive posts 202 molded by a gap-fill material 210, and a re-distribution layer 220 electrically connected to the plurality of dies 201 and the conductive posts 202. The re-distribution layer 220 includes a plurality of bonding pads 221 and an insulating layer 222 surrounding the plurality of bonding pads 221.

According to an embodiment of the present invention, the plurality of dies 201 may include the same function dies or different function dies. According to an embodiment of the present invention, the plurality of dies 201 may include dummy dies or bridging dies.

According to an embodiment of the present invention, the semiconductor structure 30 includes a plurality of dies 301 and conductive posts 302 molded by a gap-fill material 310, and a re-distribution layer 320 electrically connected to the plurality of dies 301 and the conductive posts 302. The re-distribution layer 320 includes a plurality of bonding pads 321 and an insulating layer 322 surrounding the plurality of bonding pads 321. According to an embodiment of the present invention, opposite to the re-distribution layer 320, the semiconductor structure 30 further includes a re-distribution layer 330. The re-distribution layer 330 includes a plurality of bonding pads 331 and an insulating layer 332 surrounding the plurality of bonding pads 331. The plurality of bonding pads 221 of the semiconductor structure 20 may be respectively directly bonded to the plurality of bonding pads 331 of the semiconductor structure 30.

According to an embodiment of the present invention, the conductive posts 202 embedded in the gap-fill material 210 are electrically connected to the re-distribution layer 220, and the conductive posts 302 embedded in the gap-fill material 310 are electrically connected to the re-distribution layers 320 and 330.

According to an embodiment of the present invention, the plurality of dies 301 may include the same function dies or different function dies. According to an embodiment of the present invention, the plurality of dies 301 may include dummy dies or bridging dies.

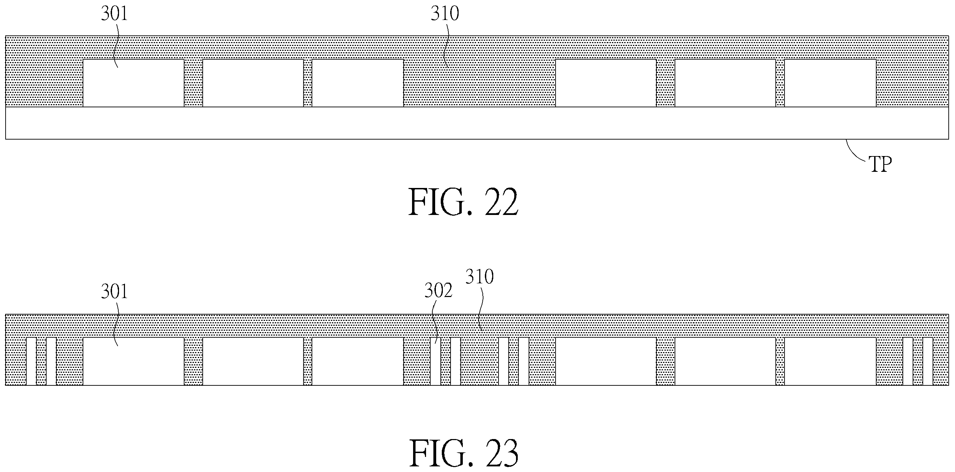

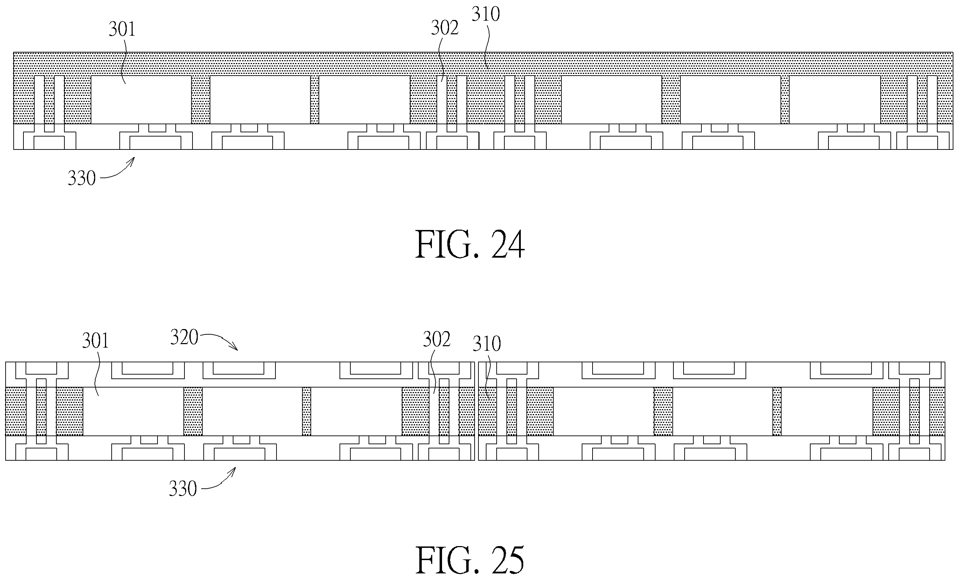

For example, the manufacturing method of the re-constructed module wafer RW2 is illustrated in FIG. 22 to FIG. 25, wherein like regions, layers or elements are designated by like numeral numbers or labels. As shown in FIG. 22, re-arranged die 301 are placed on the temporary carrier TP in a flip-chip manner. The plurality of dies 301 are then molded with a gap filling material 310. As shown in FIG. 23, after the removal of the temporary carrier TP, recess etching and metallization processes are performed to form conductive posts 302 in the gap-fill material 310 around the dies 301. As shown in FIG. 24, the RDL process is then performed to form a re-distribution layer 330 on the exposed front surface of the die 301 and the conductive pillar 302. As shown in FIG. 25, part of the gap filling material 310 is removed by grinding to expose the backside of each die 301 and the conductive posts 302, and then the RDL process is performed on the exposed backside of each die 301 and the conductive posts 302, thereby forming a re-distribution layer 320.

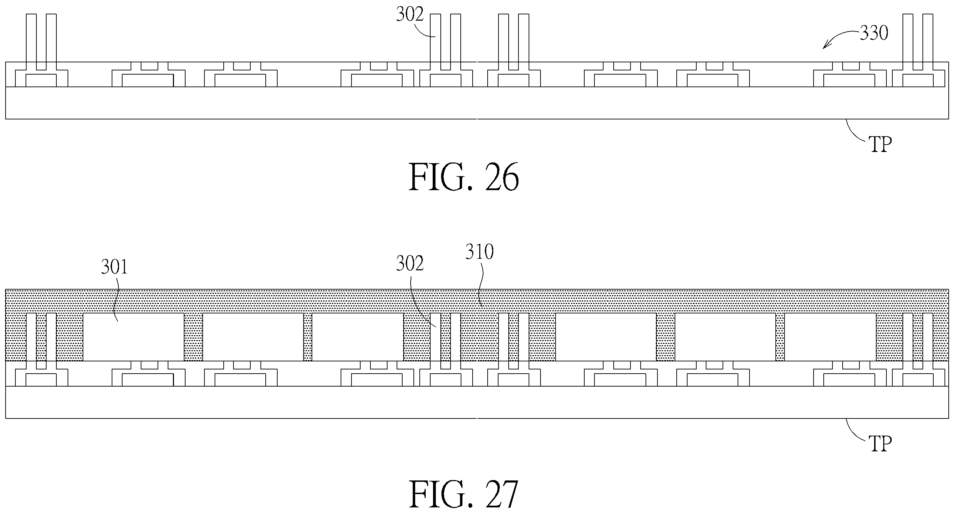

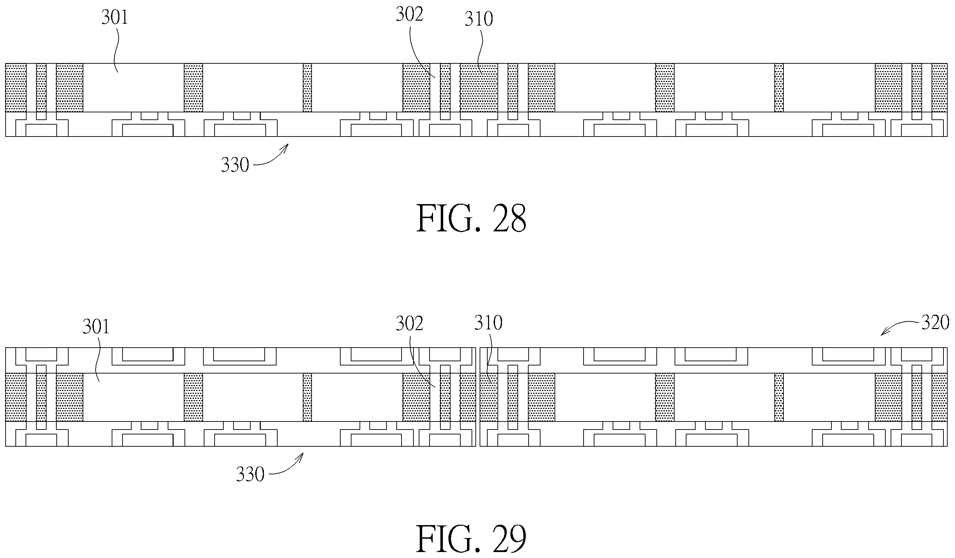

For example, another manufacturing method of the re-constructed module wafer RW2 is illustrated in FIG. 26 to FIG. 29, wherein like regions, layers or elements are designated by like numeral numbers or labels. As shown in FIG. 26, a re-distribution layer 330 is formed on the temporary carrier TP, and then the conductive posts 302 are disposed on the re-distribution layer 330. As shown in FIG. 27, re-arranged dies 301 are disposed on the re-distribution layer 330, and then the plurality of die 301 and conductive posts 302 are molded with a gap filling material 310. As shown in FIG. 28, a portion of the gap-fill material 310 is removed by grinding, exposing the backside of the die 301 and the conductive pillar 302. As shown in FIG. 29, the RDL process is then performed to form a re-distribution layer 320 on the exposed backside of each die 301 and the conductive posts 302.

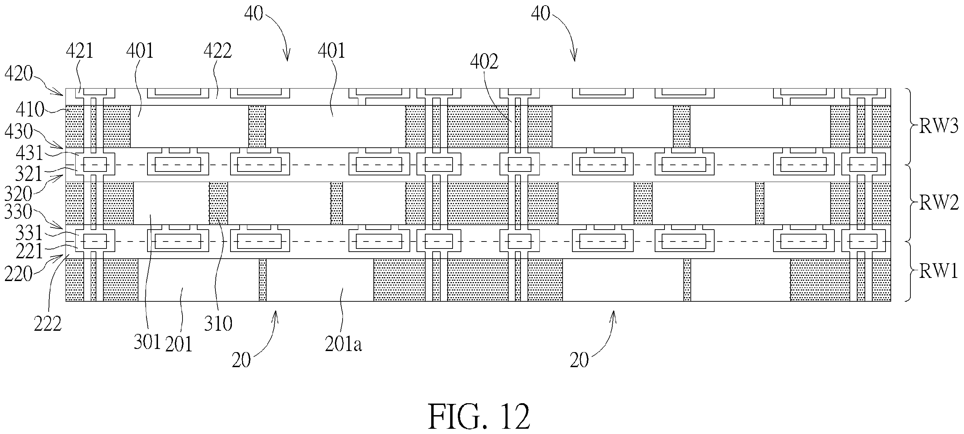

As shown in FIG. 12, a re-constructed module wafer RW3 is provided, wherein the re-constructed module wafer RW3 includes a plurality of semiconductor structures 40. The re-constructed module wafer RW3 and the re-constructed module wafer RW2 are bonded to each other by hybrid bonding technology.

According to an embodiment of the present invention, the semiconductor structure 40 includes a plurality of dies 401 and conductive posts 402 molded by a gap-fill material 410, and a re-distribution layer 420 electrically connected to the plurality of dies 401 and the conductive posts 402. The re-distribution layer 420 includes a plurality of bonding pads 421 and an insulating layer 422 surrounding the plurality of bonding pads 421. According to an embodiment of the present invention, opposite to the re-distribution layer 420, the semiconductor structure 40 further includes a re-distribution layer 430. The re-distribution layer 430 includes a plurality of bonding pads 431 and an insulating layer 432 surrounding the plurality of bonding pads 431. The plurality of bonding pads 431 of the semiconductor structure 40 may be respectively directly bonded to the plurality of bonding pads 321 of the semiconductor structure 30. The conductive posts 402 embedded in the gap-fill material 410 electrically connect the re-distribution layers 420 and 430.

According to an embodiment of the present invention, the plurality of dies 401 may include the same function dies or different function dies. According to an embodiment of the present invention, the plurality of dies 401 may include dummy dies or bridging dies.

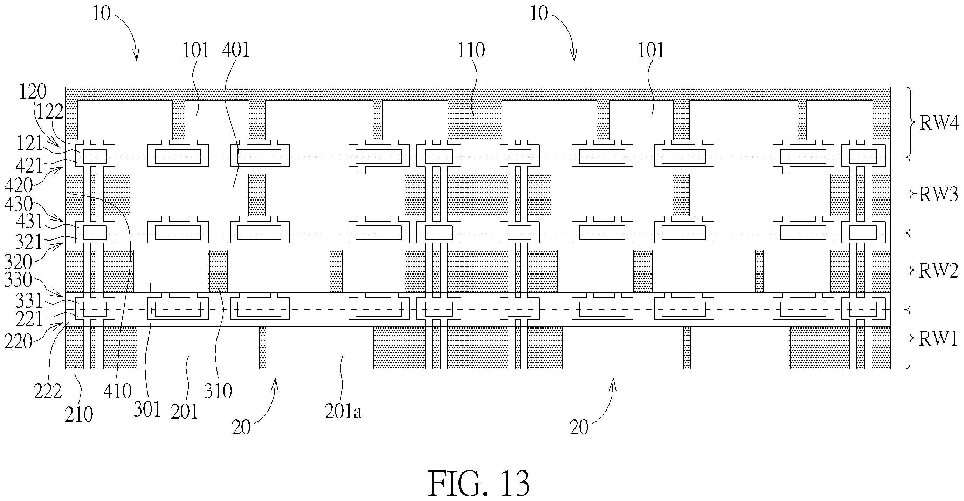

As shown in FIG. 13, a re-constructed module wafer RW4 is provided, wherein the re-constructed module wafer RW4 includes a plurality of semiconductor structures 10 as depicted in FIG. 4. The re-constructed module wafer RW4 and the re-constructed module wafer RW3 are then bonded together using a hybrid bonding technique.

According to an embodiment of the present invention, the semiconductor structure 10 includes a plurality of dies 101 molded by a gap-fill material 110, and a re-distribution layer 120 electrically connected to the plurality of dies 101, wherein the re-distribution layer 120 includes a plurality of bonding pads 121, and an insulating layer 122 surrounding the plurality of bonding pads 121. The plurality of bonding pads 421 of the semiconductor structure 40 may be respectively directly bonded to the plurality of bonding pads 121 of the semiconductor structure 10.

According to an embodiment of the present invention, the plurality of dies 101 may include the same function dies or different function dies. According to an embodiment of the present invention, the plurality of dies 101 may include dummy dies or bridging dies.

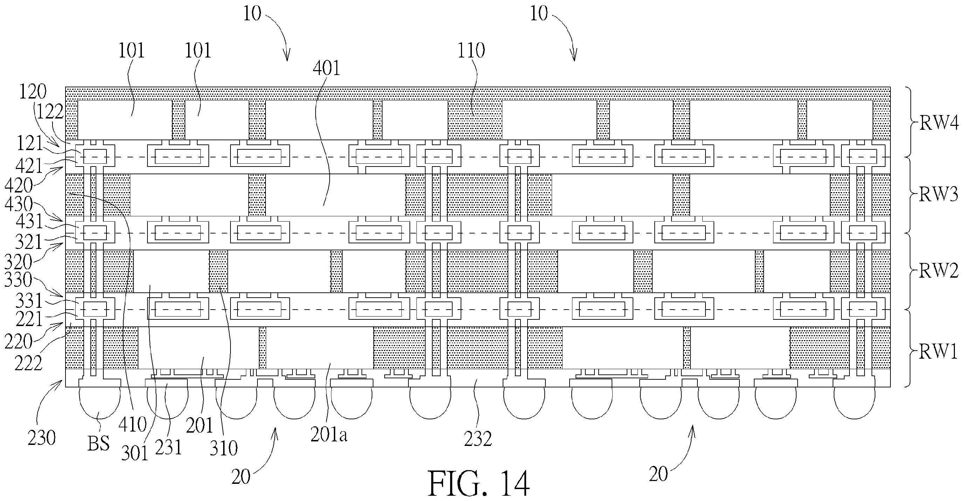

As shown in FIG. 14, a re-distribution layer 230 is then formed on the side of the semiconductor structure 20 opposite to the re-distribution layer 220. The re-distribution layer 230 includes a plurality of solder ball pads 231 and an insulating layer 232 surrounding the plurality of solder ball pads 231. A plurality of connecting elements BS may then be formed on the re-distribution layer 230. According to an embodiment of the present invention, the plurality of connecting elements BS may include solder bumps or solder balls.

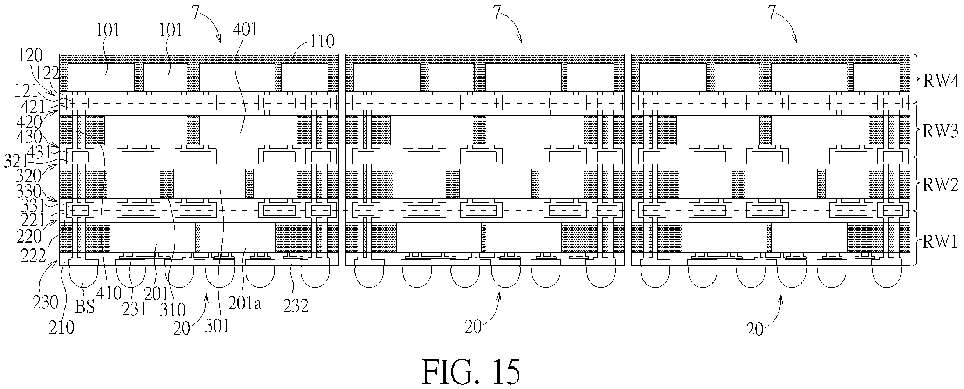

As shown in FIG. 15, a wafer dicing process is then performed to form a plurality of individual three-dimensional integrated circuit structures 7.

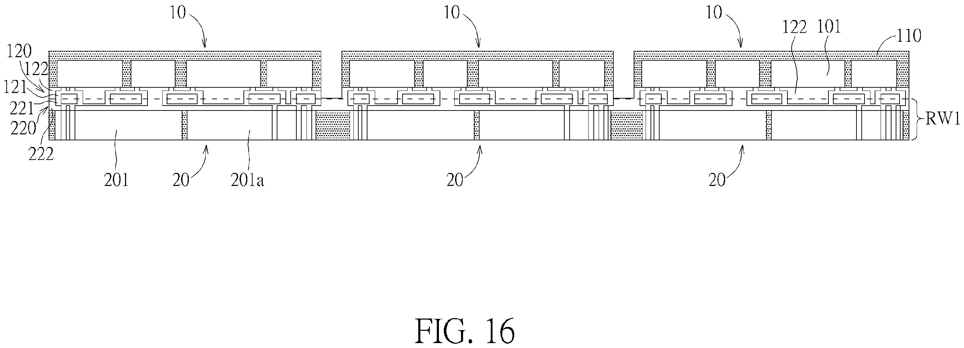

Please refer to FIG. 16 to FIG. 18, which illustrate a method for forming a three-dimensional integrated circuit structure by module-to-reconstructed module wafer hybrid bonding. As shown in FIG. 16, a re-constructed module wafer RW1 and a plurality of semiconductor structures 10 are provided, wherein the re-constructed module wafer RW1 includes a plurality of semiconductor structures 20 as depicted in FIG. 1. The re-constructed module wafer RW1 and the plurality of semiconductor structures 10 are then bonded together using a hybrid bonding technique.

According to an embodiment of the present invention, the semiconductor structure 10 includes a plurality of dies 101 molded by a gap-fill material 110, and a re-distribution layer 120 electrically connected to the plurality of dies 101, wherein the re-distribution layer 120 includes a plurality of bonding pads 121, and an insulating layer 122 surrounding the plurality of bonding pads 121.

According to an embodiment of the present invention, the plurality of dies 101 may include the same function dies or different function dies. According to an embodiment of the present invention, the plurality of dies 101 may include dummy dies or bridging dies.

According to an embodiment of the present invention, the semiconductor structure 20 includes a plurality of dies 201 molded by a gap-fill material 210, and a re-distribution layer 220 electrically connected to the plurality of dies 201. The plurality of dies 201 may include at least one TSV die 201a. The re-distribution layer 220 includes a plurality of bonding pads 221 and an insulating layer 222 surrounding the plurality of bonding pads 221. The plurality of bonding pads 221 of the semiconductor structure 20 are respectively directly bonded to the plurality of bonding pads 121 of the semiconductor structure 10.

According to an embodiment of the present invention, the plurality of dies 201 may include the same function dies or different function dies. According to an embodiment of the present invention, the plurality of dies 201 may include dummy dies or bridging dies.

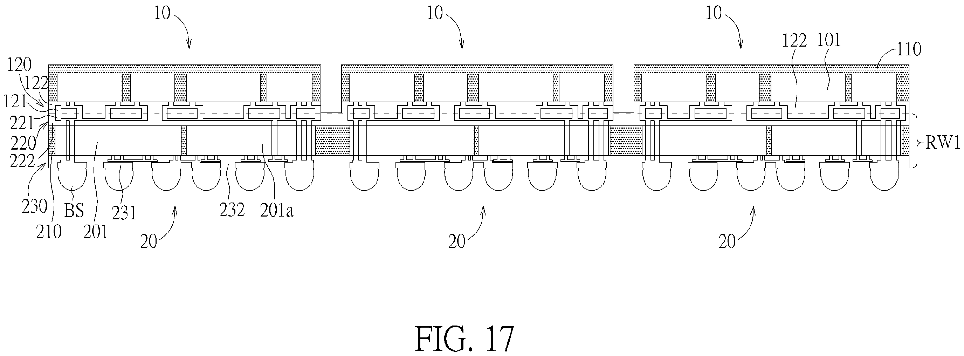

As shown in FIG. 17, a re-distribution layer 230 is then formed on the side of the semiconductor structure 20 opposite to the re-distribution layer 220. The re-distribution layer 230 includes a plurality of solder ball pads 231 and an insulating layer 232 surrounding the plurality of solder ball pads 231. A plurality of connecting elements BS may then be formed on the re-distribution layer 230. According to an embodiment of the present invention, the plurality of connecting elements BS may include solder bumps or solder balls.

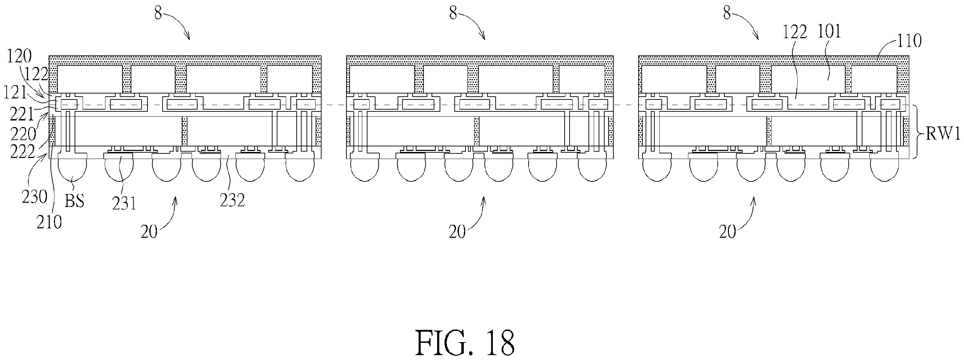

As shown in FIG. 18, a wafer dicing process is then performed to form a plurality of individual three-dimensional integrated circuit structures 8.

## Claims

1. A three-dimensional, 3D, integrated circuit structure (1), comprising:
a first semiconductor structure (10) comprising a first plurality of dies (101) molded by a first gap-fill material (110), and a first re-distribution layer (120) electrically connected to the first plurality of dies (101), wherein the first re-distribution layer (120) comprises a plurality of first bonding pads (121) and a first insulating layer (122) around the plurality of first bonding pads (121); and
a second semiconductor structure (20) comprising a second plurality of dies (201) molded by a second gap-fill material (210), wherein the second plurality of dies (201) comprises at least one through-silicon via, TSV, die (201a), and a second re-distribution layer (220) electrically connected to the second plurality of dies (201), wherein the second re-distribution layer (220) comprises a plurality of second bonding pads (221) and a second insulating layer (222) around the plurality of second bonding pads (221), wherein the plurality of first bonding pads (121) is directly bonded to the plurality of second bonding pads (221), respectively.

2. The 3D integrated circuit structure (1) according to claim 1,
wherein the plurality of first bonding pads (121) and the plurality of second bonding pads (221) comprise copper pads; or
wherein the first insulating layer (122) and the second insulating layer (222) comprise silicon oxide, silicon nitride, or silicon carbonitride; or
wherein the first insulating layer (122) is directly bonded to the second insulating layer (222).

3. The 3D integrated circuit structure (1) according to claim 1 or 2 further comprising:
a third re-distribution layer (230) disposed on a side of the second semiconductor structure (20) opposite to the second re-distribution layer (220).

4. The 3D integrated circuit structure (1) according to claim 3 further comprising:
a plurality of connecting elements (BS) disposed on the third re-distribution layer (230).

5. The 3D integrated circuit structure (1) according to claim 4, wherein the plurality of connecting elements comprises solder bumps or solder balls.

6. The 3D integrated circuit structure (1) according to claim 3 or 4, wherein the TSV die (201a) comprises a plurality of through-silicon vias for electrically connecting the second re-distribution layer (220) with the third re-distribution layer (230); or
wherein the 3D integrated circuit structure (1) further comprises a plurality of conductive posts embedded in the first gap-fill material for electrically connecting to the second re-distribution layer (220).

7. The 3D integrated circuit structure (1) according to one of the claims 1 to 6, wherein the first gap-fill material (110) and the second gap-fill material (210) comprise dielectric material or molding compound.

8. A method of fabricating a three-dimensional, 3D, integrated circuit structure (1), comprising:
forming a first semiconductor structure (10) comprising a first plurality of dies (101) molded by a first gap-fill material (110), and a first re-distribution layer (120) electrically connected to the first plurality of dies (101), wherein the first re-distribution layer (120) comprises a plurality of first bonding pads (121) and a first insulating layer (122) around the plurality of first bonding pads (121);
forming a second semiconductor structure (20) comprising a second plurality of dies (201) molded by a second gap-fill material (210), and a second re-distribution layer (220) electrically connected to the second plurality of dies (201), wherein the second re-distribution layer (220) comprises a plurality of second bonding pads (221) and a second insulating layer (222) around the plurality of second bonding pads (221); and
hybrid bonding the first semiconductor structure (10) and the second semiconductor structure (20), wherein the plurality of first bonding pads (121) is directly bonded to the plurality of second bonding pads (222), respectively.

9. The method according to claim 8, wherein the plurality of first bonding pads (121) and the plurality of second bonding pads (221) comprise copper pads; or
wherein the first insulating layer (122) and the second insulating layer (222) comprise silicon oxide, silicon nitride, or silicon carbonitride; or
wherein the first insulating layer (122) is directly bonded to the second insulating layer (222).

10. The method according to claim 8 or 9 further comprising:
forming a third re-distribution layer (230) on a side of the second semiconductor structure (20) opposite to the second re-distribution layer (220).

11. The method according to claim 10 further comprising:
forming a plurality of connecting elements (BS) on the third re-distribution layer (230).

12. The method according to claim 11, wherein the plurality of connecting elements (BS) comprises solder bumps or solder balls.

13. The method according to one of the claims 10 to 12,
wherein the second plurality of dies (201) comprises a through-silicon via, TSV, die (201a), wherein the TSV die comprises a plurality of through-silicon vias for electrically connecting the second re-distribution layer (220) with the third re-distribution layer (230); or
wherein the method further comprises forming a plurality of conductive posts in the first gap-fill material for electrically connecting to the second re-distribution layer.

14. The method according to one of the claims 8 to 13, wherein the first gap-fill material (110) and the second gap-fill material (210) comprise dielectric material or molding compound.

15. A three-dimensional, 3D, integrated circuit structure (1), comprising:
a first semiconductor structure (10) comprising a first plurality of dies (101) and a plurality of conductive posts molded by a first gap-fill material (110), and a first re-distribution layer (120) electrically connected to the first plurality of dies (101) and the plurality of conductive posts, wherein the first re-distribution layer (120) comprises a plurality of first bonding pads and a first insulating layer (122) around the plurality of first bonding pads (121); and
a second semiconductor structure (20) comprising a second plurality of dies (201) molded by a second gap-fill material (210), a second re-distribution layer (220) electrically connected to the second plurality of dies (201), and a third re-distribution layer (230) disposed on a side of the second semiconductor structure (20) opposite to the second re-distribution layer (220);
wherein the second re-distribution layer (220) comprises a plurality of second bonding pads (221) and a second insulating layer (222) around the plurality of second bonding pads, wherein the plurality of first bonding pads (121) is directly bonded to the plurality of second bonding pads (221), respectively.

## Amended claims

### Amended claims in accordance with Rule 137(2) EPC.

1. A three-dimensional, 3D, integrated circuit structure (1), comprising:
a first semiconductor structure (10) comprising a first plurality of dies (101) molded by a first gap-fill material (110), and a first re-distribution layer (120) electrically connected to the first plurality of dies (101), wherein the first re-distribution layer (120) comprises a plurality of first bonding pads (121) and a first insulating layer (122) around the plurality of first bonding pads (121); and
a second semiconductor structure (20) comprising a second plurality of dies (201) molded by a second gap-fill material (210), wherein the second plurality of dies (201) comprises at least one through-silicon via, TSV, die (201a), and a second re-distribution layer (220) electrically connected to the second plurality of dies (201), wherein the second re-distribution layer (220) comprises a plurality of second bonding pads (221) and a second insulating layer (222) around the plurality of second bonding pads (221), wherein the plurality of first bonding pads (121) is directly bonded to the plurality of second bonding pads (221), respectively.

2. The 3D integrated circuit structure (1) according to claim 1,
wherein the plurality of first bonding pads (121) and the plurality of second bonding pads (221) comprise copper pads; or
wherein the first insulating layer (122) and the second insulating layer (222) comprise silicon oxide, silicon nitride, or silicon carbonitride; or
wherein the first insulating layer (122) is directly bonded to the second insulating layer (222).

3. The 3D integrated circuit structure (1) according to claim 1 or 2 further comprising:
a third re-distribution layer (230) disposed on a side of the second semiconductor structure (20) opposite to the second re-distribution layer (220).

4. The 3D integrated circuit structure (1) according to claim 3 further comprising:
a plurality of connecting elements (BS) disposed on the third re-distribution layer (230).

5. The 3D integrated circuit structure (1) according to claim 4, wherein the plurality of connecting elements comprises solder bumps or solder balls.

6. The 3D integrated circuit structure (1) according to claim 3 or 4, wherein the TSV die (201a) comprises a plurality of through-silicon vias for electrically connecting the second re-distribution layer (220) with the third re-distribution layer (230); or
wherein the 3D integrated circuit structure (1) further comprises a plurality of conductive posts embedded in the first gap-fill material for electrically connecting to the second re-distribution layer (220).

7. A method of fabricating a three-dimensional, 3D, integrated circuit structure (1), comprising:
forming a first semiconductor structure (10) comprising a first plurality of dies (101) molded by a first gap-fill material (110), and a first re-distribution layer (120) electrically connected to the first plurality of dies (101), wherein the first re-distribution layer (120) comprises a plurality of first bonding pads (121) and a first insulating layer (122) around the plurality of first bonding pads (121);
forming a second semiconductor structure (20) comprising a second plurality of dies (201) molded by a second gap-fill material (210), and a second re-distribution layer (220) electrically connected to the second plurality of dies (201), wherein the second re-distribution layer (220) comprises a plurality of second bonding pads (221) and a second insulating layer (222) around the plurality of second bonding pads (221); and
bonding the first semiconductor structure (10) and the second semiconductor structure (20), wherein the plurality of first bonding pads (121) is directly bonded to the plurality of second bonding pads (222), respectively.

8. The method according to claim 7, wherein the plurality of first bonding pads (121) and the plurality of second bonding pads (221) comprise copper pads; or
wherein the first insulating layer (122) and the second insulating layer (222) comprise silicon oxide, silicon nitride, or silicon carbonitride.

9. The method according to claim 7 or 8 further comprising:
forming a third re-distribution layer (230) on a side of the second semiconductor structure (20) opposite to the second re-distribution layer (220).

10. The method according to claim 9 further comprising:
forming a plurality of connecting elements (BS) on the third re-distribution layer (230).

11. The method according to claim 10, wherein the plurality of connecting elements (BS) comprises solder bumps or solder balls.

12. The method according to one of the claims 9 to 11,
wherein the second plurality of dies (201) comprises a through-silicon via, TSV, die (201a), wherein the TSV die comprises a plurality of through-silicon vias for electrically connecting the second re-distribution layer (220) with the third re-distribution layer (230); or
wherein the method further comprises forming a plurality of conductive posts in the first gap-fill material for electrically connecting to the second re-distribution layer.
